(19) Europäisches Patentamt / European Patent Office / Office européen des brevets

(11) **EP 4 654 022 A2**

(12) **EUROPEAN PATENT APPLICATION**

(43) Date of publication:
**26.11.2025 Bulletin 2025/48**

(21) Application number: **25177400.6**

(22) Date of filing: **19.05.2025**

(51) International Patent Classification (IPC):
*G06F 11/34* (2006.01)  *G06F 11/30* (2006.01)

(52) Cooperative Patent Classification (CPC):
**G06F 11/3438; G06F 11/3006; G06F 11/302;
G06F 11/3419; G06F 11/3447; G06F 11/3457;
G06F 11/3495; G06N 20/00; H04L 43/08;**
G06F 11/3409; G06F 2201/865; G06F 2201/875

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **24.05.2024  US 202463651424 P
05.05.2025  US 202519198812**

(71) Applicant: **Dynatrace LLC
Waltham, MA 02451 (US)**

(72) Inventors:
• **THOMPSON, Guilherme**
  **Linz (AT)**
• **LABURU, Aitor**
  **Linz (AT)**
• **SADEGHI, Rezvan**
  **Linz (AT)**

(74) Representative: **Steffens, Adrian
Boehmert & Boehmert
Anwaltspartnerschaft mbB
Pettenkoferstraße 22
80336 München (DE)**

(54) **CONNECTING WEB PERFORMANCE WITH USER EXPERIENCE**

(57)    The disclosure relates to a computer-implemented method for simulating performance of a web application. The technical problem solved by the disclosure is to identify aspects of a web application that greatly affect user retention and to quantify user retention by modifying the identified aspects of the web application. This is solved by a collecting monitoring data associated with interactions between users and the web application; training a machine learning model with training data; generating virtual performance metrics for the web application; simulating a rate of users leaving the web application based on the virtual performance metrics; identifying at least one modified performance metric causing a change in user retention; and outputting a recommendation specific to the web application.

**Fig. 1**

## Description

Field

The present disclosure relates to the broad field of information technology. In particular, the disclosure relates to a computer-implemented method for simulating performance of a web application thereby connecting web performance with user experience. In addition, the disclosure relates to a computer-implemented method for optimizing performance of a web application. Finally, the disclosure relates to a non-transitory computer-readable medium having computer-executable instructions that, upon execution of the instructions by a processor of a computer, cause the computer to simulate or optimize the performance of a web application.

Background

Optimizing performance and reducing errors on a website can be challenging, requiring deep knowledge of the interplay between user experience (short UX) features as well as back and front-end resources. Traditionally, the methods used to improve these aspects have been based on static recommendations not tailored to a site's specific user base and their experiences and expectations. While these methods have been useful in identifying when users face issues such as poor performance or front-end and network errors, it has been difficult to determine how these problems impact the business.

The present disclosure takes an innovative approach by utilizing machine learning to analyze a website's real user data and identify the primary performance metrics and errors affecting the users' experience on each application page. It also quantifies the predicted business impact of optimization, allowing business and application owners to make informed decisions based on the biggest impact on their bottom line.

It has long been known that performance significantly impacts user experience. Users facing poor performance or errors are likelier to abandon a website or application. Numerous studies have demonstrated the correlation between poor performance and an increased website abandonment rate. However, these studies have two main limitations: Firstly, they are based on specific case studies concerning a particular type of application, user, time etc. So, how can we know if your customers respond in the same way to performance degradation? Secondly, while we know that reducing a webpage's loading time can likely decrease page abandonment, it is unclear what improvement we can expect if we, for example, reduce the loading time by 100 ms. Is it 0.1 %, 1 %, or 50 %? How can we evaluate whether the cost of implementing an improvement positively impacts business? Moreover, is it always necessary to reach the recommended benchmarks? E.g., if we have a page that takes 10 s to load, do we need to improve it to 2 s? Or would an improvement to 5 s be enough to significantly reduce abandonment?

While Digital Experience Monitoring solutions according to the prior art use simple correlations or estimates, none has been able to solve this problem with a robust causal model. This is where the disclosure presented in this document comes in. It uses machine learning to analyze real user data from a website and identifies the primary performance or error metrics affecting the user experience on each page. It also quantifies the predicted business impact of optimization, allowing business and application owners to make informed decisions, e.g., based on the biggest impact on their bottom line.

This section provides background information related to the present disclosure which is not necessarily prior art.

Summary

This section provides a general summary of the disclosure, and is not a comprehensive disclosure of its full scope or all of its features.

The disclosure answers the following critical questions: 1. If we could enhance just one performance aspect of the website / application, which one should it be? 2. What would be the impact if the website/application were error-free? 3. By how much should one or more performance metrics be improved? 4. What is the anticipated improvement in user retention by implementing such enhancements?

The technical problem solved by the disclosure is to identify aspects of a web application that greatly affect user retention and to quantify user retention by modifying the identified aspects of the web application.

According to a first aspect of the disclosure, this is solved by a computer-implemented method for simulating performance of a web application. Advantageous embodiments are described herein.

Concretely, the technical problem is solved by a computer-implemented method for simulating performance of a web application, the computer-implemented method comprising: collecting monitoring data associated with interactions between users and the web application, the monitoring data comprising performance metrics related to the performance of the web application and events for users leaving the web application; training a machine learning model with training data, wherein the training data is a subset of the monitoring data; generating virtual performance metrics for the web application by modifying one or more of the performance metrics in the monitoring data; simulating, with the trained machine learning model, a rate of users leaving the web application based on the virtual performance metrics; identifying at least one modified performance metric from the virtual performance metrics causing a change in the rate of users leaving the web application; and outputting a recommendation specific to the web application based on the at least one modified performance metric causing the change in the rate of users leaving the web application.

In the first step, a large number, typically millions, of real user sessions are utilized to comprehend which web performance elements typically have the most significant impact on your users. Subsequently, a machine learning model is trained with training data, wherein the training data is a subset of the monitoring data. After these steps, virtual performance metrics are generated for the web application by modifying one or more of the performance metrics in the monitoring data. Next, the rate of users leaving the web application is simulated for said virtual performance metrics using the trained machine learning model. The simulation answers the question of how much user retention is changed by changing the web application according to the virtual performance metrics. After the simulation, at least one, typically multiple, modified performance metric from the virtual performance metrics causing a change in the rate of users leaving the web application is identified; and a recommendation specific to the web application is output based on the at least one modified performance metric causing the change in the rate of users leaving the web application.

Typically, the disclosed method is performed for multiple client applications, thereby capturing the nuanced differences that characterize the real users of each application.

In order to improve the accuracy of the simulating performance of the web application, the monitoring data is preprocessed prior to training the machine learning model.

Advantageously, the preprocessing step further includes performance metrics in the monitoring data that are at least partially represented by categorical variables: generating a matrix with categorical variables split into distinct columns such that each column represents a specific performance metric of the performance metrics.

In addition, missing values in categorical variables in the matrix are identified; and filled out such that the matrix no longer contains missing values. Missing values can e.g., be replaced by "unknown" categorical values.

According to a very preferred embodiment, preprocessing the monitoring data further includes: splitting the monitoring data into a plurality of data sets including a first data set with data having influence on users leaving the web application, a second data set with data having no influence on users leaving the web application, and a third data set with data registering users leaving the web application; and generating the training data for the machine learning model with only the first data set with data having influence on users leaving the web application.

Preferably, the method further comprises: identifying the recommendation specific to the web application based on an inflection point of a simulation curve for user retention results from the simulation. At the inflection point, the curvature of user retention changes sign, e.g., from positive to negative or vice versa. The client's understanding of user retention-related performance metrics is greatly enhanced by identifying such points.

Beneficially, the method further comprises: determining rates of users leaving the web application by simulating, multiple times with the trained machine learning model, a rate of users leaving the web application based on the virtual performance metrics having different modifications to the performance metrics in the monitoring data, each simulation with the trained machine learning model is based on a different modification to the performance metrics in the monitoring data; and comparing user retention results from the multiple simulations based on the different modifications to the performance metrics in the monitoring data, and ranking the virtual performance metrics based on the user retention results.

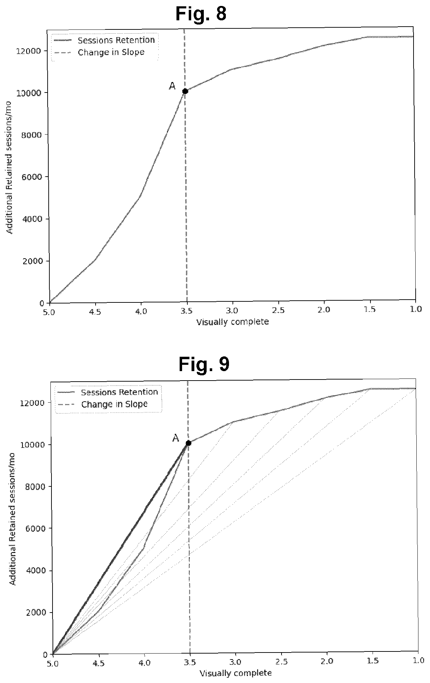

In order to enable the identification of effective recommendations the method further comprises the ranking of the virtual performance metrics, e.g., by selecting the virtual performance metric having the greatest rate of retained users or sessions over the virtual performance metric (see e.g., Fig. 9). Selecting can be facilitated by computing the first derivative of retained users/sessions over the virtual performance metric.

The machine learning model is preferably a Gradient Boosting Machine model. According to another very preferred embodiment, the machine learning model utilizes monotonic constraints.

According to a second aspect of the disclosure, the objective technical problem is solved by a computer-implemented method for optimizing performance of a web application. Advantageous embodiments are described herein.

Concretely, the technical problem is solved by a computer-implemented method for optimizing performance of a web application, the computer-implemented method comprising: collecting monitoring data associated with interactions between users and the web application, the monitoring data comprising performance metrics related to the performance of the web application and events for users leaving the web application; training a machine learning model with training data, wherein the training data is a subset of the monitoring data; generating virtual performance metrics for the web application by modifying one or more of the performance metrics in the monitoring data; simulating, with the trained machine learning model, a rate of users leaving the web application based on the virtual performance metrics; identifying one modified performance metric from the virtual performance metrics causing a change in the rate of users leaving the web application; and modifying the web application such that the performance metrics of the web application corresponds to or resembles the identified modified performance metric to optimize the performance of the web application.

Instead of analyzing the performance of the web application and outputting a recommendation of how to improve the performance of the web application, the performance of the web application is optimized by modifying the web application.

According to a third aspect of the disclosure, the objective technical problem is solved by a non-transitory computer-readable medium having computer-executable instructions that, upon execution of the instructions by a processor of a computer, causes the computer to perform any one or more of the methods herein.

Concretely, the technical problem is solved by a non-transitory computer-readable medium having computer-executable instructions that, upon execution of the instructions by a processor of a computer, cause the computer to: collect monitoring data associated with interactions between users and a web application, the monitoring data comprising performance metrics related to performance of the web application and events for users leaving the web application; train a machine learning model with training data, wherein the training data is a subset of the monitoring data; generate virtual performance metrics for the web application by modifying one or more of the performance metrics in the monitoring data; simulate, with the trained machine learning model, a rate of users leaving the web application based on the virtual performance metrics; identify one modified performance metric from the virtual performance metrics causing a change in the rate of users leaving the web application; and modify the web application such that the performance metrics of the web application corresponds to or resembles the identified modified performance metric to optimize the performance of the web application.

Further areas of applicability will become apparent from the description provided herein. The description and specific examples in this summary are intended for purposes of illustration only and are not intended to limit the scope of the present disclosure.

Drawings

The drawings and tables described herein are for illustrative purposes only of selected embodiments and not all possible implementations, and are not intended to limit the scope of the present disclosure.

| | |
|---|---|
| Fig. 1 | schematically shows a matrix A of monitoring data and a vector Y of the binary response variable, |
| Fig. 2 | shows the structure of a composite meta model used in the application examples, |
| Fig. 3 | shows an example of a causal inference model comprising performance metric variables X and covariates p of monitoring data, |
| Fig. 4 | shows another example of a causal inference model comprising performance metric variables X and covariates p of monitoring data, |
| Fig. 5 | schematically shows fitting of models with and without monotonic constraints, |
| Fig. 6 | schematically shows the distributions of a model before and after transformation, |
| Fig. 7 | shows a scheme of classes involved in simulations, |
| Fig. 8 | shows an inflection point A in a simulated number of additional retained sessions/month over the visually complete time, |
| Fig. 9 | shows in addition to Fig. 8 various slopes/derivates in the simulated number of additional retained sessions/month over the visually complete time, |
| Figs. 10 to 18 | (also referred to TABS. 1 - 9) show tables for the first application example, |
| Fig. 19 | shows the predicted exit rates for page 1 of the webstore in the first application example, |
| Figs. 20 to 22 | (also referred to TABS. 10 - 12) show tables for the second application example, |
| Fig. 23 | shows a flow chart of main steps in a computer-implemented method for simulating performance of a web application, and |
| Fig. 24 | shows a flow chart of main steps in a computer-implemented method for optimizing performance of a web application. |

Corresponding reference numerals indicate corresponding parts throughout the several views of the drawings.

Detailed description

Example embodiments will now be described more fully with reference to the accompanying drawings and tables.

In general, the disclosure comprises four main components:

1. Enhanced Bot Detection and Preprocessing: This component is responsible for filtering out non-human traffic and preparing the data for analysis.

2. Causal AI Model: This is essentially the machine learning model. It employs machine learning techniques to identify the primary performance or error metric influencing each page's user experience.

3. What-if Simulations: This component conducts multiple simulations to predict the impact of each investigated scenario.

4. Opportunity ranking: This component audits the scenarios to find the optimal level of enhancement that maximizes user retention. It also quantifies the anticipated business impact of optimization.

The following paragraphs briefly describe these components:

1. Enhanced Bot Detection and Preprocessing: This component gathers, combines, and preprocesses the data on the actions performed by users in the analyzed application. This information is utilized to discover the relationship between user experience and behavior using the machine learning model.

Here are some examples of context variables (covariates p):

Browser type: Identifies whether the user is a mobile or desktop user
Browser family: Identifies the browser family utilized by the user
ISP: Specifies the user's internet Service Provider
Country: Denotes the user's country
Region: Indicates the user's region
OS family: Identifies the operating system employed during the user session
Screen orientation: the detected screen orientation (LANDSCAPE or PORTRAIT) of the device used for the user session
Display resolution: The detected screen resolution of the user's device
Is new user: Differentiates between new and returning users
Action name: Name of the action executed by the user
Action type: Type of user action (Load or XMLHttpRequest, short XHR)
Action index: User action sequence number

**[0034]** Some examples of performance and error variables are:

Action duration: Measures the time taken to complete the page load
Speed index: Is a score that measures the time until the visible parts of the page are rendered
Visually complete time: Measures how long it takes until the webpage is fully loaded visually and ready to be used
Load event end: The time taken to complete the load event of the page
Dom complete time: The time taken until the page's status is set to "complete"
Largest contentful paint: The time taken to render the largest element in the viewport Cumulative layout shift: Measures the page's visual stability
First input delay: The time from the first interaction with the page to when the user agent can respond to that interaction

Total time between user interaction and response: measuring the lapsed time between a user interaction with the page and when user gets a response for this interaction. The following variables are related to this:

Request start: The time before the user agent sends the request to obtain the page from the server, relevant application caches, or a local resource,
Response start (Time to first byte): The lead time of the first byte of the response is received from the server, relevant application caches, or a local resource,
Response end: The time taken until the user agent receives the last byte of the response or the transport connection is closed, whichever comes first, and
First input delay (see above)
JavaScript errors details: aggregation of all JavaScript errors that occurred during the action, presented as a list
Request errors details: aggregation of all request errors that occurred during the action, also presented as a list
The target variable typically is "Is exit" and measures whether or not the user exited in this action. It is what we want to predict/analyze.

Once the data is prepared, an enhanced bot detection system is employed. This approach guarantees that the machine learning model only considers sessions we can confidently associate with genuine users.

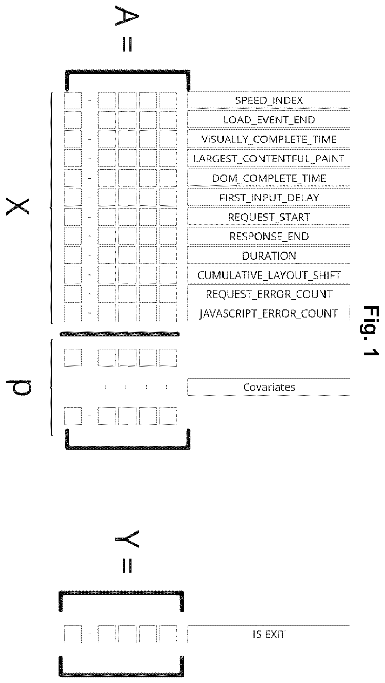

2. Causal AI model: We start by defining our problem mathematically: Suppose we have a matrix A composed of two types of variables (see Fig. 1). The X variables are related to performance and errors, being actionable variables we can influence. The p variables (in prior art also called p- or $\rho$-variables), are covariates, including factors such as Internet Service Provider (ISP), country, and device type, over which we have no direct control. Furthermore, the covariates mainly represent the traffic profile of a given application.

In addition, we have a binary response variable Y, representing whether the analyzed action is the last in a session, thus indicating whether the user abandoned the application after that action.

Fig. 1 shows a schema of the matrix A comprising X- and p- variables, and the vector of the binary response variable Y.

The model we use is a function $f_\theta : M \longrightarrow \mathbb{R}$, which maps each row vector a from matrix $A \in \mathbb{R}^{D \times N}$ to a real value, where $M$ is the space of positive row vectors of length $D = |X| + |p|$ and $N$ is the number of events (user interactions in analyzed sessions). The parameters of $f$ are denoted by $\theta$; at this point, they are unknown but will be obtained through training.

We apply the sigmoid function $\sigma : \mathbb{R} \longrightarrow (0,1)$ to the output of $f_\theta$ to map its real outputs into probabilities between 0 and 1 (indicating the probability that the session ends). Mathematically, the sigmoid is defined as $x \mapsto (1 + e^{-x})^{-1}$. Hence, our model $g_\theta : M \rightarrow (0,1)$, defined $a \mapsto \sigma(f_\theta(a))$.

During the training process, we adjust the parameters $\theta$ of $f_\theta$ to minimize the discrepancy between the model predictions $g_\theta(a)$ and the actual values y, using binary cross-entropy:

$$\min_\theta \ -\sum_{i=1}^{N} y_i \log\big(g(a_i)\big) + (1 - y_i) \log\big(1 - g(a_i)\big)$$

Additionally, we know that the gradients of the variable X with respect to $a$ are always negative, indicating an inverse relationship between these variables and the probabilities of the user exiting the application. Hence, we impose that:

$$\frac{\partial g_\theta}{\partial x} > 0 \ \forall x \in X$$

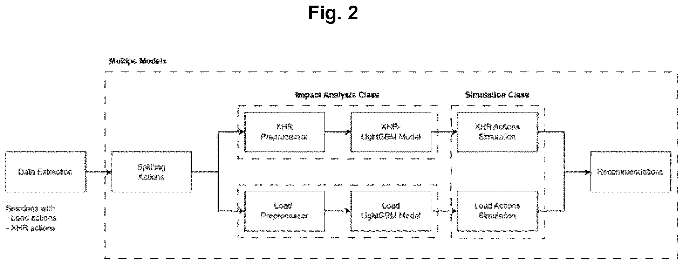

Regarding the implementation of this fundamental equation, our causal model is a composite (meta) model comprising distinct models within a single class, as shown in Fig. 2.

The specific model used internally depends on the type of action being analyzed, although the end user interacts with a unified model. This is attributed to the fact that each model possesses a unique causal graph tailored to the available metrics and prioritizes the most explanatory ones. In these causal graphs, as said before, we can identify two types of variables:

Performance and error variables have a positive monotonic relationship with the probability of exit of a session. These are variables that we can modify or improve and will be modified in the simulation stage.

Covariate variables or context variables: these variables provide context to the model when estimating the probability of exit of a session. These remain fixed in the simulation stage.

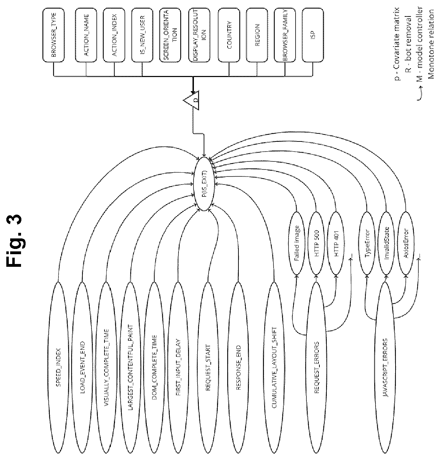

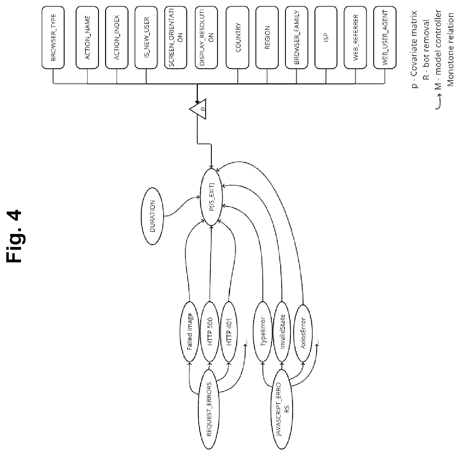

An example of the Causal Graph for the Load model and the XHR model is given in Figs. 3 and 4, respectively.

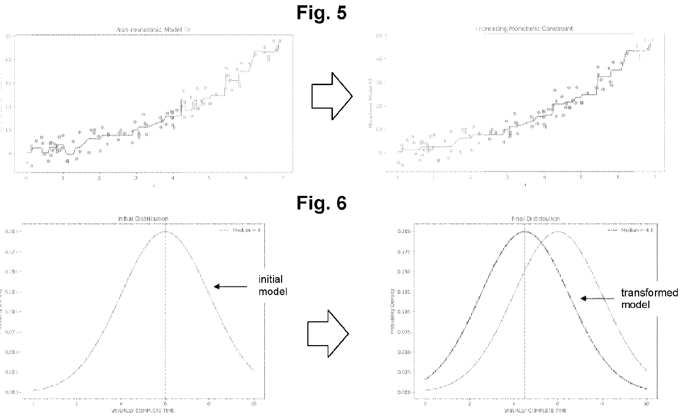

To ensure the model accurately captures the metrics as delineated in the graph and the mathematical expression, we utilize monotonic constraints. This is because a higher page performance correlates with a decrease (or at least a constant rate) in exit probability (see Fig. 5).

Delving into the specifics of the impact analysis models, each of them is composed of two key elements: the data preprocessor and the ML model, e.g., a constrained LightGBM model.

The former prepares the data for the machine learning model, including tasks like identifying common JavaScript errors (from JavaScript error details) and converting them to one hot encoding. The latter, a variant of the LightGBM, incorporates modifications to account for the monotonic relationship of the variables and additional optimization functions. LightGBM was chosen for its state-of-the-art performance, efficiency in training and inference, ease of integrating monotonic variables, and GPU-accelerated training capabilities. It is understood that other ML models can be used delivering similar results.

These two components are integrated into the impact analysis class, which adheres to the scikit learn API and includes methods for interacting with Snowflake, such as saving and loading models from a stage. Lastly, the multi-model impact analysis class segregates the Load and XHR actions, selects the appropriate model and metrics for each action type, trains the models, evaluates them, combines them, and stores them in Snowflake.

The precision of our causal model varies across clients, but it generally achieves a balanced accuracy of approximately 80% and an AUC (area under curve) of 0.86. All the classes outlined here were developed in Python, leveraging libraries such as scikit learn, pandas, numpy, snow-park, lightgbm, etc.

3. What-if Simulations: At this point, we have developed a machine learning model that identifies correlations between performance and errors to an increased likelihood of webpage exits. However, this model's utility is limited without a method to convert these findings into actionable insights. The challenge lies in quantifying the impact of performance degradation on different user types. For instance, do new Linux users exhibit the same behavior as returning Mac users? How can we translate these insights into specific recommendations, such as "Improve the speed index of page 1 by 15% to reduce the exit rate by 2%" or "Fix the JavaScript error on page 2 to decrease the exit rate by 1.5%"? To address this, we employ simulations. We utilize real user data and our trained model and then generate univariate modifications for each performance metric. We then evaluate the potential improvement and repeat the process with further improvement until a maximum improvement threshold is reached. Schematically, we do the following:

We define an empirical distribution for each variable to reflect the new simulated value (generally the median). For each sample, the intervention changes the value of a given variable x, mapping it to its homologue on the new CDF (Cumulative Distribution Function) such that:

$$x'(x) = F'_X \left( F_X^{-1}(x) \right)$$

In this version, we are applying a linear operator $T$ such that $F'_X(x) = F_X(cx)$. The constant c is chosen so the median of the transformed model matches the evaluated scenario. The initial model before transformation has a median value of 6 and the transformed model has a median value of 4.5; the respective distributions of the models are depicted in Fig. 6.

We repeat this analysis for each performance and error variable. The analysis is conducted at the level of action type, browser (mobile, desktop, all), action (for at least the 20/30 most significant actions of the application for each action type), and each performance metric and error. In one example, the simulation is executed for the following metrics:

Load action metrics:

- Speed index: A simulation point is generated every 0.5 s between the current value and 1 s. For example, if the current median is 5, simulations will be performed for 4.5, 4, 3.5, 3, 2.5, 2, 2, 1.5, 1.

- Visually complete time: A simulation point is generated every 0.5 s between the current value and 1 s.

- Load event end: A simulation point is generated every 0.5 s between the current value and 1 s.

- Dom complete time: A simulation point is generated every 0.5 s between the current value and 1 s.

- Largest contentful paint: A simulation point is generated every 0.5 s between the current value and 1 s.

- Cumulative layout shift: A simulation point is generated every 0.01 between the current value and 0.05.

- First input delay: A simulation point is generated every 100 ms between the current value and 100 ms.

- Request start: A simulation point is generated every 100 ms between the current value and 100 ms.

- Response start (Time to first byte): A simulation point is generated every 100 ms between the current value and 100 ms.

- Response end: A simulation point is generated every 100 ms between the current value and 100 ms.

- JavaScript error details: The five most frequent JavaScript errors across all sessions are identified. Subsequently, we simulate the outcomes if we fix each error (in separate simulations).

- Request error details: The five most frequent request errors across all sessions are identified. Subsequently, we simulate the outcomes if we fix each error (in separate simulations).

<u>XHR action metrics:</u>

- Action duration: A simulation point is generated every 100 ms between the current value and 100 ms.
- JavaScript error details: The five most frequent JavaScript errors across all sessions are identified. Subsequently, we simulate the outcomes if we fix each error (in separate simulations).
- Request error details: The five most frequent request errors across all sessions are identified. Subsequently, we simulate the outcomes if we fix each error (in separate simulations).

As we can observe, our simulation handles various types of browsers (mobile, desktop, all), actions (Load and XHR), and metrics (in seconds, milliseconds, dimensionless, integers, etc.). To manage these variations, we utilize a set of specialized classes for each simulation type, which are subsequently combined within a general class shows a schematic representation of all the classes involved in the simulation.

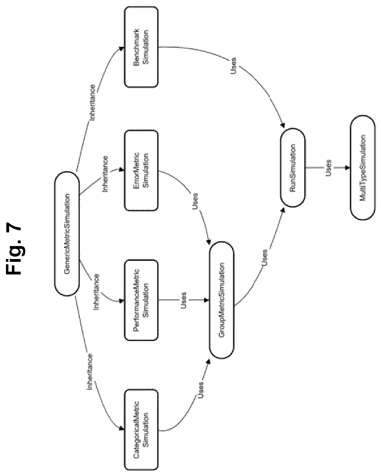

The following paragraph gives a brief description of each class, see also Fig. 7:
Generic Metric Simulation Class: This is a generic class that includes various methods common to all the simulation classes, such as scaling and prediction using the machine learning model.

Performance Metric Simulation Class: This class handles performance simulations. Unlike errors, metrics like action duration are continuous, allowing us to decide the extent of their improvement. This class creates a grid of simulations, applies the machine learning model to each, and measures the expected improvement.

Error Metric Simulation Class: This class manages the simulation of general error counts. As errors can only be fixed or not, it is a binary simulation.

Benchmark simulation: This class answers the question: What would happen if I improve all metrics to the values recommended by Dynatrace? It represents an ideal situation, estimating the maximum improvement a website page can achieve.

Custom Error Metric Simulation Class: Like the Error class, but it expects a list of errors instead of a single error (JavaScript errors details and Request errors details). It fixes one error at a time and measures the improvement in the analyzed action.

Group metric simulation: This class takes an action to analyze (for example, the home page), runs all possible simulations, and evaluates the expected improvements for each metric.

Run simulation: This class takes all actions to analyze for a specific type of action (Load or XHR) and runs simulations for each browser type in parallel.

Multi Type Simulation: This is a higher-level class than Run simulation. It runs the simulation process for both Load and XHR, with the appropriate metric type for each, and combines the results.

4. <u>Opportunity Ranking:</u> At this point, we have all possible simulations. However, we need to transform these into recommendations and rank them. Preferably, the model can be used to find the optimal improvement point for each action type, browser, page, and metric, that is, the point where minimal effort yields maximum results. We currently define this point as the inflection point of the simulation curve (see schematic in Fig. 8). In Fig. 8, the model identifies the inflection point A as the recommended point, since it is where the slope between the current point and the simulated value is maximum (the break in the improvement curve can be seen).

If we draw all the improvement slopes, we can see that at point A this slope is maximum (see Fig. 9). However, the user can decide to continue with the improvements or stop earlier: the model provides the expected results for each level of improvement.

Let us give one example: Assuming we simulate 20 XHR and 20 Load actions for each browser type (mobile, desktop, all) for each performance metric. The number of potential improvements is quite high: for Load, we are talking about 20 actions, 3 browsers, and approximately 20 metrics (10 performance and 10 errors), resulting in 1200 potential improvements, plus approximately 660 for XHR. Reviewing 1860 potential improvements may not seem very enjoyable, right? Therefore, our model identifies the optimal point for each combination of action type, browser, page, and metric. It then ranks each of these optimal points from highest to lowest based on the number of additional sessions retained, and creates an importance ranking from most impactful to least impactful. By doing so, a ranking of improvements is generated, ordered by the potential number of retained sessions if the improvement were implemented.

After this general introduction, let us focus on two simple application examples.

In a first application example, the principle of the disclosure will be explained. Assume that a company operates a simple webstore comprising three webpages, namely page 1, page 2 and page 3. Users visit the webstore and the interaction between users and the webstore is monitored by an application performance monitoring system. In particular, the monitoring system logs data associated to the loading of the webpages, such as

- the variable SESSION_ID containing the session ID of the user,

- the variable ACTION_NAME logging the name of the webpage loaded by the user,
- the variable ISP containing the Internet Service Provider used by the user to access the internet,
- the variable SPEED_INDEX containing the speed index as an indicator for the speed of loading the webpage,
- the variable VISUALLY_COMPLETE_TIME containing the time from starting to load the certain webpage until rendering the webpage is complete,
- the variable ERROR_NAMES holding the names of errors (if any) occurring during loading the webpage, and finally
- the variable IS_EXIT describing whether the user left after loading the respective webpage.

The variables SESSION_ID, ACTION_NAME, ISP and ERROR_NAMES are categorical variables, of which SESSION_ID is an integer. The variables SPEED_INDEX and VISUALLY_COMPLETE_TIME represent numerical float values. Finally, the variable IS_EXIT is a binary variable, i.e. it can only have the value 0 (for user is not exiting) or 1 (user is exiting).

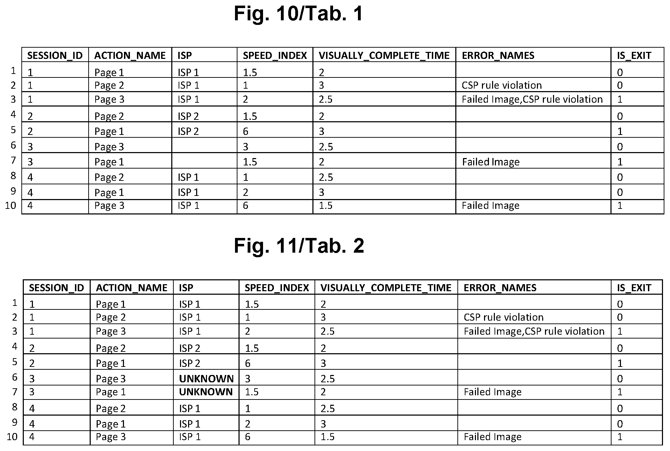

The data logged by the monitoring system is given in Fig. 10/Tab. 1. Note that the index on the left side is printed for convenience only and is not part of the logged data. The list of errors contained in column ERROR_NAMES are separated by colons, such that e.g., line 3 contains two errors. The first type of error "CSP rule violation" concerns violations of the content security policy. The second type of error "Failed Image" concerns an error while loading an image on the webpage. In addition it is noted that lines 6 and 7 do not contain entries for the field ISP. The reason for that could be that the user is using an old internet browser or the browser did not give the ISP to the monitoring system, e.g. due to security settings. Irrespective of the reason, some fields in column "ISP" of the monitoring data may be missing.

The objective of the disclosure is to find parameters in the monitoring data that have an influence on whether users decide to leave a website or not. In addition, the effect of changing these parameters on the number of users leaving the website shall be estimated.

In a first step, missing parts in the categorical variables of the monitoring data are filled up. In this case, the missing parts in the column ISP are filled up with "UNKNOWN", see bold printed in Fig. 11/Tab. 2. After this, all fields contain values. It is noted that numerical values (such as SPEED_INDEX) are not changed.

In a second step, the columns of the monitoring data are separated into four parts, namely

first a set of columns having no influence on the number of users exiting the website; this set can be empty or not. Generally, the first set comprises variables that cannot be generalized to the rest of the users and therefore are not included (for example a user ID, or the session ID), or that are constant in the analysis;

second a set of columns having an influence on users exiting the website, which the website operator cannot influence. Also this set can be empty or not;

third at least one column having an influence on users exiting the website, which the website operator can influence; and

fourth a column registering users exiting the website.

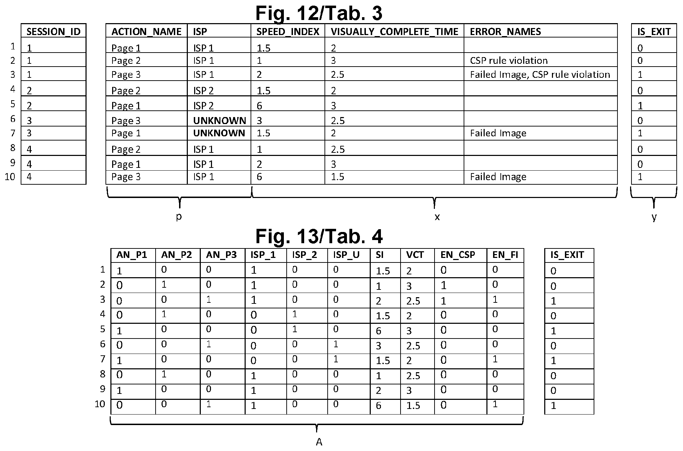

The columns having no influence on users exiting the website will be omitted in the subsequent analysis. The columns having an influence on users exiting the website, which the website operator cannot influence are referred to as p-variables. The columns having an influence on users exiting the website, which the website operator can influence are referred to as x-variables. And finally, the column registering users exiting the website is referred to as y-vector. The p- and x-variables as well as the y-vector are displayed in Fig. 12/Tab. 3.

In a third step, denumerable values in the p- and x-variables are separated into individual columns. E.g., the column ACTION_NAME is split into three columns for pages 1 to 3 (short AN_P1, AN_P2, AN_P3), the column ISP is split into three columns too for ISP 1, ISP 2 and UNKNOWN (short ISP_1, ISP_2, ISP_U), and the column ERROR_NAMES are split into two columns for "CSP rule violation" (short EN_CSP) and "Failed Image" (short EN_FI) . The p-und x-variables form the A-matrix. The result is shown in Fig. 13/Tab. 4.

In a fourth step, a Machine Learning (short ML) model is trained on the monitoring data. Preferably, training the ML model forces a monotonic relationship between certain variables and the probability of user exiting. The ML model with these monotonic constraints creates, in a way, a first version of a causal model. By training the ML model on the monitoring data of Fig. 13/Tab. 4 it is assumed that the model learns the following rules:

If

$$EN\_FI == 1 \rightarrow IS\_EXIT = 1$$

If

9

$$SI \geq 6 \rightarrow IS\_EXIT = 1.$$

The first rule realizes that if a Failed Image Error occurs during loading the webpage, the user exits. The second rule realizes that if the Speed Index is greater or equal to 6, the user exits.

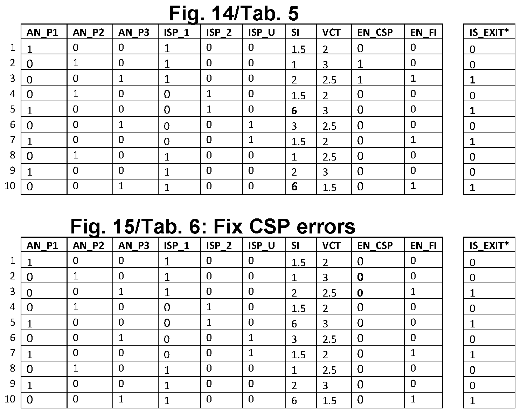

The effect of training the ML model is shown in Fig. 14/Tab. 5. Lines 3 and 7 give examples for the 1st rule where EN_FI == 1 and the user exits the webshop, and line 5 is an example for the 2nd rule where SI == 6 and the user exits the webstore, too. Line 10 gives an example for the combination of the 1st and the 2nd rule EN_FI == 1 and where SI == 6, such that the user also leaves the webstore (IS_EXIT = 1). As the rightmost column reflects the predictions by the ML model, IS_EXIT was renamed to IS_EXIT*.

Before performing simulations based on the trained ML model, the current situation given in Tab. 4 is analyzed. Based on all observations for pages 1-3, users left the webstore in 40% of all cases. Broken down to the individual pages, users left page 1 in 50%, page 2 in 0% and page 3 in 67% of all cases.

In a fifth step, various simulations are performed how changing certain values of x-variables changes the y-variable. In other words, simulations are performed on changing variables the store operator can change and how these changes influence the predicted exit rate IS_EXIT*. For the simulation, the trained ML model is used.

In a first simulation, the effect of fixing CSP errors is investigated. Based on the current situation in Fig. 13/Tab. 4, the errors in line 2 and 3 are fixed, i.e. in lines 2 and 3 the entries in column "EN_CSP" are changed to 0 (printed bold in Fig. 15/Tab. 6). Changing these values, however, does not change the predicted rate for users exiting the webstore (see variable IS_EXIT* for the predicted value of IS_EXIT). In other words, the exit rates are the same as in the current situation.

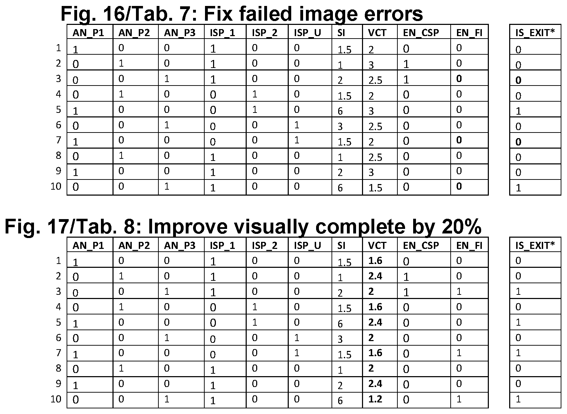

In a second simulation, the effect of fixing "Failed Image" errors is investigated. Based on the current situation in Fig. 13/Tab. 4, the errors in lines 3, 7 and 10 are fixed, i.e. the entries in column "EN_FI" are changed to 0 (printed bold in Fig. 16/Tab. 7). Changing these values, changes the predicted rate for users exiting the webstore considerable (see IS_EXIT* in lines 3 and 7 for the predicted value of IS_EXIT). In fact, fixing these errors reduces the total exit rate to 20%, and the exit rates for pages 1 to 3 to 25%, 0% and 33%, respectively.

In a third simulation, the effect of reducing the "VISUALLY_COMPLETE_TIME" (short VCT) by 20%, i.e. by multiplying the given times in column VCT of Tab. 4 by a factor of 0.8, is investigated. Changing these values, however, does not change the predicted rate for users exiting the webstore (see Fig. 17/Tab. 8).

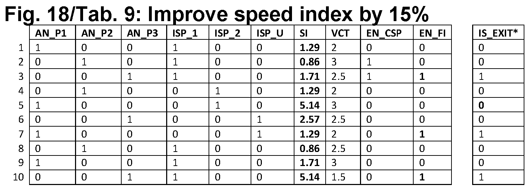

In a fourth simulation, the effect of reducing the speed index by some 15% (from an average value of 1.75 to 1.5, i.e. by multiplying the given times in column SI of Tab. 4 by a factor of 0.857), is investigated. Changing the values in column SI, changes the predicted rate for users exiting the webstore in line 5 from 1 to 0 (printed bold in Fig. 18/Tab. 9). In total, improving the speed index reduces the total exit rate to 30%, and the exit rates for pages 1 to 3 to 25%, 0% and 67%, respectively.

Finally, in a fifth simulation, the effect of reducing the speed index by some 43% (from an average of 1.75 to 1, i.e. by multiplying the given times in column SI of Tab. 4 by a factor of 0.57), is investigated. In total, improving the speed index reduces the total exit rate to 30%, and the exit rates for pages 1 to 3 to 25%, 0% and 67%, respectively. In other words, improving the speed index from 1.5 to 1, does not further improve the predicted exit rates.

Improvements are not limited to addressing one parameter only. Based on the ML model, several parameters can be changed and the effect on the predicted exit rates can be estimated. In this example, addressing "Failed Image" errors and improving the speed index appear to be the most effective strategies for reducing exit rates.

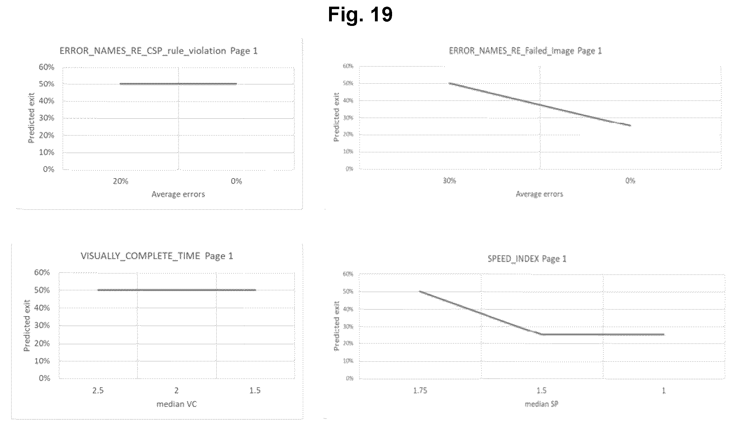

The effects of changing certain parameters on the predicted exit rate for page 1 of the webstore are shown in Fig. 19.

After explaining the principles of the disclosure in a first application example, the procedure is shown again in a more complex second example. Instead of describing the disclosed method verbally, the procedure is implemented in the programming language Python.

The code for loading the required modules in Python is:

```
import lightgbm as Igb
import numpy as np
import pandas as pd
from matplotlib import pyplot as plt
from sklearn import set_config
from sklearn.compose import ColumnTransformer
from sklearn.model_selection import train_test_split
from sklearn.preprocessing import MultiLabelBinarizer, OneHotEncoder
# Define random seed for repeatability
np.random.seed(42)
set_config(transform_output="pandas")
```

In order to make the code repeatable, a random seed is specified. As ML model, the well-known LightGBM model in Python is used. In LightGBM, "GBM" stands for Gradient Boosting Machine and "Light" stands for high speed and memory efficiency. LightGBM is a free and open-source distributed gradient-boosting framework for machine learning.
The following Python code is used to produce monitoring data:

```
def generate_dataset(num_sessions: int) -> pd.DataFrame:


    # Define the possible values and settings
    pages = [« Page 1 », « Page 2 », « Page 3 »]
    isps = [« ISP 1 », « ISP 2 », None]


    # Performance distribution settings
    visually_complete_min = 0.5
    visually_complete_max = 1.2
    speed_index_mean_exit_0 = 1.0
    speed_index_std_exit_0 = 0.5
    speed_index_mean_exit_1 = 10.0
    speed_index_std_exit_1 = 0.5


    # Initialize the dataset container
    data = []


    # N actions per session
    min_actions = 1
    max_actions = 4


    # Generate data for each session
    for session_id in range(1, num_sessions + 1):
        num_actions = np.random.randint(min_actions, max_actions)
```

```
isp = np.random.choice(isps)

for action_id in range(num_actions):
    is_exit = 1 if action_id == num_actions – 1 else 0
    page = np.random.choice(pages)
    visually_complete_time = np.random.uniform(
        visually_complete_min, visually_complete_max
    )

    # Set SPEED_INDEX based on IS_EXIT
    if is_exit:
        if np.random.random() < 0.9:
            speed_index = np.random.normal(
                speed_index_mean_exit_1, speed_index_std_exit_1
            )
        else:
            speed_index = np.random.normal(
                speed_index_mean_exit_0, speed_index_std_exit_0
            )
    else:
        speed_index = np.random.normal(
            speed_index_mean_exit_0, speed_index_std_exit_0
        )

    # Set errors
    errors = []
    if np.random.random() < 0.01:
        errors.append("CSP rule violation")
    if is_exit and np.random.random() < 0.99:
        errors.append("Failed Image")
    error_names = ",".join(errors) if errors else None

    # Collect all action data
    action_data = {
        "SESSION_ID": session_id,
        "ACTION_NAME": page,
```

```
            "ISP": isp,

            "SPEED_INDEX": speed_index,

            "VISUALLY_COMPLETE_TIME": visually_complete_time,

            "ERROR_NAMES": error_names,

            "IS_EXIT": is_exit,

        }
        data.append(action_data)


    data = pd.DataFrame(data)

    return data
```

As in the 1st application example, monitoring data from users loading three webpages, namely page 1, page 2 and page 3, of a simple webstore is used. The above function generate_dataset generates random monitoring data for a variable number of user sessions.

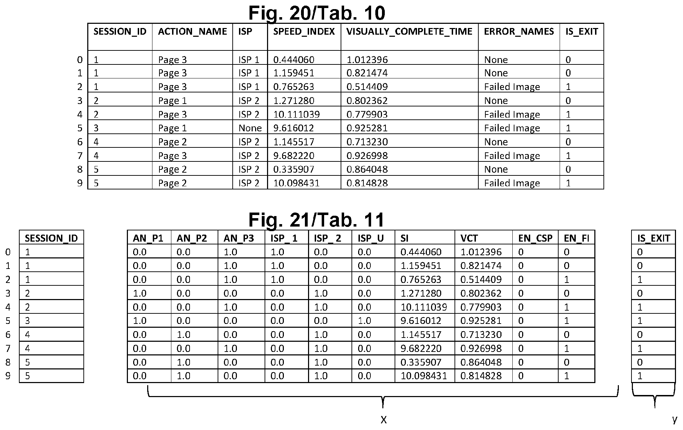

Calling "df = generate_dataset(num_sessions=100000)" produces monitoring data for 100000 user sessions and assigns the monitoring data to the dataframe df. Some rows of the dataframe df are printed below (see also Fig. 20/Tab. 10):

| SESSION_ID | ACTION_NAME | ISP | SPEED_INDEX | VISUALLY_COMPLETE_TIME | ERROR_NAMES | IS_EXIT |
|---|---|---|---|---|---|---|
| 0 | Page 3 | ISP 1 | 0.444060 | 1.012396 | None | 0 |
| ... | ... | ... | ... | ... | ... | ... |
| 17 | Page 1 | None | 10.146536 | 0.613140 | CSP rule violation,Failed Image | 1 |
| ... | ... | ... | ... | ... | ... | ... |
| 99997 | Page 1 | None | 8.959866 | 0.856847 | Failed Image | 1 |

The leftmost column in the table above shows an index, which is not part of the dataframe. As in the 1st application example, some entries in the column ISP are missing; these are printed as "None". In addition, two types of errors can occur, namely "Failed Image" and "CSP rule violation".

The monitoring data is preprocessed in order to split enumerable categorical variables into distinct columns and to fill missing values in the dataframe. The preprocessing is performed by the function preprocess_data:

```
def preprocess_data(data):

  # Fill UNKNOWN values for contextual variables (in this case only ISP)

  data["ISP"] = data["ISP"].fillna("UNKNOWN")

  data["ERROR_NAMES"] = data["ERROR_NAMES"].str.split(",").fillna("")

  mlb = MultiLabelBinarizer()
  errors_encoded = pd.concat(
      [
        data.drop("ERROR_NAMES", axis=1),
        pd.DataFrame(mlb.fit_transform(df["ERROR_NAMES"]), columns=mlb.classes_),
      ],
      axis=1,
  )
  ohe = OneHotEncoder(sparse_output=False)
  ct = ColumnTransformer(
      [("encoder", ohe, ["ACTION_NAME", "ISP"])], remainder="passthrough"
  )
  df_encoded = ct.fit_transform(
      errors_encoded,
  )

  # Clean column names
  df_encoded.columns = [col.replace("encoder_", "") "") for col in df_encoded.columns]
  df_encoded.columns = [col.replace("remainder__", "") for col in df_encoded.columns]

  return df_encoded, mlb.classes_
```

The function preprocess_data performs the following main steps on the dataframe df:

1. Fill Missing Values for ISP:
The function fills any missing (NA) values in the "ISP" column with the string "UNKNOWN". This ensures that all rows have a valid value for the ISP context.
2. Process ERROR_NAMES Column:
The "ERROR_NAMES" column is split by commas (,), creating a list of error names for each row. Any missing values in this column are replaced with an empty list.
3. Encode Categorical Variables:
The function uses a MultiLabelBinarizer to encode the error names into binary columns (one-hot encoding). Each unique error name becomes a separate column, and a value of 1 indicates the presence of that error for a specific row.

The original "ERROR_NAMES" column is dropped from the DataFrame, and the new binary columns are concatenated with the remaining columns.

4. One-Hot Encode ACTION_NAME and ISP:
The function applies one-hot encoding to the "ACTION_NAME" and "ISP" columns using a ColumnTransformer. The transformed DataFrame includes the one-hot encoded columns along with any remaining columns (passed through unchanged).
5. Clean Column Names:
The column names are cleaned by removing the prefixes "encoder_" and "remainder_" that were added during the encoding process.

Overall, this function preprocesses the input DataFrame by handling missing values, encoding categorical variables, and creating a new DataFrame with transformed features. This is useful for preparing the data for machine learning.

Calling df_transformed, error_names = preprocess_data(data=df) assigns the preprocessed data to the dataframe df_transformed.

The first 10 rows of df_transformed are given in Fig. 21/Tab. 11. As in Figs. 13-18/Tabs. 4-9, AN_PX stands for Action_Name_Page X, ISP_1 and ISP_2 stand for the ISPs 1 and 2 and ISP_U stands for a missing ISP entry, SI stands for Speed Index, VCT for Visual_Complete_Time, EN_CSP stands for the error name CSP rule violation and EN_FI stands for the error name Failed Image.

After preprocessing the monitoring data, a ML model with monotonic constraints is trained. In this example, a LightGBM model is used. Training is done by calling:

```
X = df_transformed.drop(
["SESSION_ID", "IS_EXIT"], axis=1
)
y = df_transformed["IS_EXIT"]
X_train, X_test, y_train, y_test = train_test_split(
X, y, test_size=0.2, random_state=42
)

# Define the monotonic constraints (0 for all other columns)
monotone_constraints_columns = [
"SPEED_INDEX",
"VISUALLY_COMPLETE_TIME",
"Failed Image",
"CSP rule violation",
]
monotonic_constraints = [
1 if col in monotone_constraints_columns else 0 for col in X.columns
]

# Initialize the model and add class weights
model = Igb.LGBMClassifier(
class_weight="balanced",
monotone_constraints=monotonic_constraints,
random_state=42,
max_depth=2,
num_leaves=3,
)

model.fit(X_train, y_train)
```

In training the ML model, the following steps are performed:

1. Data Preparation:
The feature matrix X is created by dropping the columns "SESSION_ID" and "IS_EXIT" from the transformed DataFrame df_transformed. This prepares the feature matrix for training. In addition, y is assigned the values from the "IS_EXIT" column, representing the target variable (whether a session ended or not).
2. Train-Test Split:
The data is split into training and testing sets using train_test_split. X_train and y_train contain the features and labels for training, respectively. X_test and y_test contain the features and labels for testing, respectively. Without limitation, in the code above, a 80/20 split between training data and test data was done.
3. Monotonic Constraints:
Monotonic constraints are defined for specific columns in the feature matrix (X), namely "SPEED_INDEX", "VISUALLY_COMPLETE_TIME", "Failed Image" and "CSP rule violation". For these columns, the constraint value is set to 1 (indicating a positive monotonic relationship), while all other columns have a constraint value of 0 (no specific monotonic relationship).
4. Initialize LightGBM Classifier:
A LightGBM classifier (LGBMClassifier) is initialized with the following hyperparameters:

- class_weight="balanced": Balances class weights to handle imbalanced data.
- monotone_constraints: Use the specified monotonic constraints.
- random_state=42: Sets the random seed for reproducibility.
- max_depth=2: Limits the depth of the decision tree.
- num_leaves=3: Controls the number of leaves in the tree.

5. Model Training:
The model is trained using the training data (X_train and y_train) with the specified constraints. The trained model is stored in the variable model.

Overall, the above code prepares the data, defines monotonic constraints, initializes a LightGBM classifier, and trains it on the training set. The goal is to predict whether a session will exit based on the provided features.

For training the model, all columns of Fig. 21/Tab. 11 are used except the columns "Session_ID" and "IS_EXIT". The 10 remaining columns constitute the X matrix (in the 1st application example, called the A matrix). The y-vector is given by the column "IS_EXIT". In order to facilitate the learning of rules by the ML model, monotonic constraints are used for the columns SI, VVT, EN_FI and EN_CSP in Tab. 11. To be precise, the objective of the monotonic variables is to include our experience on how performance and probability of exit are related in reality. This forces the model to discard some correlations that are not causal and it also forces the model to learn rules that are "useful to the business".

After training the ML model, several simulations are performed using the trained model. For this, the following Python code is used:

```
# Run simulations
pages = ["ACTION_NAME_" + c for c in df["ACTION_NAME"].unique()]

performance_metrics = ["SPEED_INDEX", "VISUALLY_COMPLETE_TIME"]
min_metric_value = 1
step = 0.5

simulations = []

# Run simulations for errors
analyzed_errors = error_names

for page in pages:
    # Get data for the analyzed page
    data_subset = (
        df_transformed[df_transformed[page] == 1]
        .drop(["SESSION_ID"], axis=1)
        .copy()
    )
    current_exit_rate = data_subset["IS_EXIT"].mean()

    # current model prediction
    current_exit_rate_prediction = model.predict_proba(
        data_subset.drop("IS_EXIT", axis=1)
    )[:, 1].mean()

    # Prediction scale factor
    prediction_scale_factor = current_exit_rate / current_exit_rate_prediction

    for error in analyzed_errors:
        data_subset_scaled = data_subset.copy()
```

```python
# Get the current state of the page
current_metric_value = data_subset_scaled[
    error
].mean()


# Save current state
simulations.append(
    [page, error, current_metric_value, current_exit_rate, "current"]
)


# Start the simulation
data_subset_scaled[error] = 0  # Fix all errors


# Get the new exit rate
new_exit_rate = (
    model.predict_proba(data_subset_scaled.drop("IS_EXIT", axis=1))[:, 1].mean()
    * prediction_scale_factor
)


# Save the new exit rate
simulations.append([page, error, 0, new_exit_rate, "target"])

for metric in performance_metrics:
    # Get the current state of the page
    current_metric_value = data_subset[metric].median()


    # Save current state
    simulations.append(
        [page, metric, current_metric_value, current_exit_rate, "current"]
    )


    if current_metric_value > min_metric_value:
        # Create a grid between the current value and the minimum value
        start_value = current_metric_value – (current_metric_value % step)
        grid_list = list(np.arange(start_value, min_metric_value, -step))
```

```
        if len(grid_list) == 0:
            grid_list.append(min_metric_value)

        elif grid_list[-1] != min_metric_value:
            grid_list.append(min_metric_value)


        for point in grid_list:
            # Get the scale factor and scale the data
            scale_factor = point / current_metric_value
            data_subset_scaled = data_subset.copy()
            data_subset_scaled[metric] = data_subset_scaled[metric] * scale_factor

            new_median = data_subset_scaled[metric].median()  # For checking
            new_exit_rate = (
                model.predict_proba(data_subset_scaled.drop("IS_EXIT", axis=1))[
                    :, 1
                ].mean()
                * prediction_scale_factor
            )

            simulations.append([page, metric, point, new_exit_rate, "simulation"])

    # Create a dataframe from the simulations
    simulations_df = pd.DataFrame(
        simulations, columns=["Page", "Metric", "Value", "Exit_rate", "Type"]
    )
```

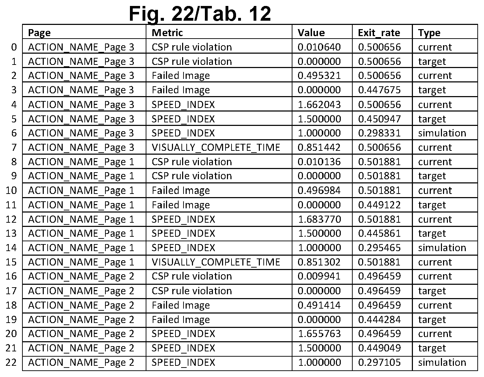

The simulation results are written to the dataframe simulations_df. Printing the results is done by calling the command simulations_df. By looking at the simulation results in Fig. 22/Tab. 12, the optimal point of improvement can be found, i.e. the variable leading to the maximum benefit - which is the greatest reduction in the predicted Exit_rate with the least effort.

For brevity, only results for page 3 will be briefly discussed: Removing all CSP errors does not change the exit rate at all (lines 0, 1). However, removing all Failed Image errors reduces the exit rate from 0.5 to 0.44 (lines 2, 3). Finally, reducing the speed index from 1.66 to 1.5 reduces the exit rate from 0.5 to 0.45. Reducing the speed index further from 1.5 to 1 reduces the exit rate from 0.45 to 0.3.

After having trained the ML model, simulations based on arbitrary data can be performed easily. Suppose we want to have the predicted output IS_EXIT* for one arbitrary data point. The code for that would be:

```
# One hypothetical data point
new_data = pd.DataFrame({
"ACTION_NAME_Page 1": [0],
"ACTION_NAME_Page 2": [0],
"ACTION_NAME_Page 3": [1],
"ISP_ISP 1": [1],
```

```
"ISP_ISP 2": [0],
"ISP_ISP UNKNOWN": [0],
"SPEED_INDEX": [0.444],
"VISUALLY_COMPLETE_TIME": [1.01],
"CSP rule violation": [0],
"Failed Image": [0],
})
# Make predictions
predicted_exit = model.predict(new_data)
print(predicted_exit)
```

The ML model predicts 0 as predicted_exit, which matches line 0 of Tab. 11. Of course, multiple data points can be simulated too. Assume that the dataframe new_data comprises lines 0, 1 and 2 of Tab. 11.

```
# Array of hypothetical new data points
new_data = pd.DataFrame({
"ACTION_NAME_Page 1": [0, 0, 0],
"ACTION_NAME_Page 2": [0, 0, 0],
"ACTION_NAME_Page 3": [1, 1, 1],
"ISP_ISP 1": [1, 1, 1],
"ISP_ISP 2": [0, 0, 0],
"ISP_ISP UNKNOWN": [0, 0, 0],
"SPEED_INDEX": [0.444, 1.16, 0.77], "VISUALLY_COMPLETE_TIME": [1.01, 0.82, 0.51],
"CSP rule violation": [0, 0, 0],
"Failed Image": [0, 0, 1],
})
# Make predictions
predicted_exit = model.predict(new_data)
print(predicted_exit)
```

In this case, the predicted variable predicted_exit matches the first three lines of the column IS_EXIT in Fig. 21/Tab. 11. In both cases, one or multiple parameters can be changed and the effect on the predicted exit rate can be seen as predicted by the ML model.

By training ML models on monitoring data, interesting insights into the behavior of users interacting with a website can be obtained. The disclosure is not limited to a specific programming language (here Python), a specific ML model (here LightGBM) or a specific action type (here the loading of individual page of a webstore).

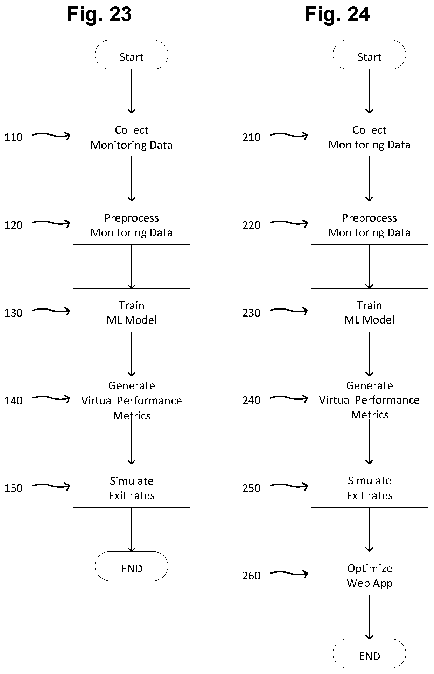

Fig. 23 schematically shows a flow chart of the main steps in a computer-implemented method for simulating performance of a web application. After starting the method, monitoring data 110 is collected for a web application or a web page. The monitoring comprises performance metrics related to the performance of the web application and events for users leaving the web application. In step 120, the collected monitoring data is preprocessed, e.g. by filling missing values and by splitting categorical variables into separate columns. After preprocessing, the monitoring data is typically split into training data and test data. In step 130, the training data, which is a subset of the preprocessed monitoring data, is used to train a machine learning model. The machine learning model is a causal AI model, e.g. a Gradient Boosting Machine model such as LightGBM. Preferably, the test data is used to gauge the accuracy of the machine learning model. In step 140, at least one vector, typically multiple vectors, corresponding to virtual performance vector metrics, are generated. The virtual performance metrics correspond to improved versions of the web application. The trained machine learning model is used in step 150 to predict exit rates of users existing the improved web application based on the virtual performance metrics. The simulated exit rates can be used to find suitable strategies for improving the performance of the web application that i) minimize the rate of users exiting the application and ii) ensure a quick amortization of the investment for improving the performance of the app.

Likewise, Fig. 24 shows a schema of the main steps in a computer-implemented method for optimizing performance of a web application. In addition to steps 210-250, which correspond to steps 110-150 in Fig. 11 described above, an additional step 260 is taken. In this step, the web application is changed such that the exit rate of users leaving the app is minimized. In other words, the virtual improvement of the web application is transformed into a real improvement of the web application. Typically, one or more performance parameters of the web app are changed that i) have a big effect on user retention, and ii) ensure quick amortization of development costs for improving the web app.

The techniques described herein may be implemented by one or more computer programs executed by one or more processors. The computer programs include processor-executable instructions that are stored on a non-transitory tangible computer readable medium. The computer programs may also include stored data. Non-limiting examples of the non-transitory tangible computer readable medium are nonvolatile memory, magnetic storage, and optical storage.

Some portions of the above description present the techniques described herein in terms of algorithms and symbolic representations of operations on information. These algorithmic descriptions and representations are the means used by those skilled in the data processing arts to most effectively convey the substance of their work to others skilled in the art.

These operations, while described functionally or logically, are understood to be implemented by computer programs. Furthermore, it has also proven convenient at times to refer to these arrangements of operations as modules or by functional names, without loss of generality.

Unless specifically stated otherwise as apparent from the above discussion, it is appreciated that throughout the description, discussions utilizing terms such as "processing" or "computing" or "calculating" or "determining" or "displaying" or the like, refer to the action and processes of a computer system, or similar electronic computing device, that manipulates and transforms data represented as physical (electronic) quantities within the computer system memories or registers or other such information storage, transmission or display devices.

Certain aspects of the described techniques include process steps and instructions described herein in the form of an algorithm. It should be noted that the described process steps and instructions could be embodied in software, firmware or hardware, and when embodied in software, could be downloaded to reside on and be operated from different platforms used by real time network operating systems.

The present disclosure also relates to an apparatus for performing the operations herein. This apparatus may be specially constructed for the required purposes, or it may comprise a computer selectively activated or reconfigured by a computer program stored on a computer readable medium that can be accessed by the computer. Such a computer program may be stored in a tangible computer readable storage medium, such as, but is not limited to, any type of disk including floppy disks, optical disks, CD-ROMs, magnetic-optical disks, read-only memories (ROMs), random access memories (RAMs), EPROMs, EEPROMs, magnetic or optical cards, application specific integrated circuits (ASICs), or any type of media suitable for storing electronic instructions, and each coupled to a computer system bus. Furthermore, the computers referred to in the specification may include a single processor or may be architectures employing multiple processor designs for increased computing capability.

The algorithms and operations presented herein are not inherently related to any particular computer or other apparatus. Various systems may also be used with programs in accordance with the teachings herein, or it may prove convenient to construct more specialized apparatuses to perform the required method steps. The required structure for a variety of these systems will be apparent to those of skill in the art, along with equivalent variations. In addition, the present disclosure is not described with reference to any particular programming language. It is appreciated that a variety of programming languages may be used to implement the teachings of the present disclosure as described herein.

The foregoing description of the embodiments has been provided for purposes of illustration and description. It is not intended to be exhaustive or to limit the disclosure. Individual elements or features of a particular embodiment are generally not limited to that particular embodiment, but, where applicable, are interchangeable and can be used in a selected embodiment, even if not specifically shown or described. The same may also be varied in many ways. Such variations are not to be regarded as a departure from the disclosure, and all such modifications are intended to be included within the scope of the disclosure.

**Claims**

1. A computer-implemented method for simulating performance of a web application, the computer-implemented method comprising:

   - collecting monitoring data associated with interactions between users and the web application, the monitoring data comprising performance metrics related to the performance of the web application and events for users leaving the web application;
   - training a machine learning model with training data, wherein the training data is a subset of the monitoring data;
   - generating virtual performance metrics for the web application by modifying one or more of the performance metrics in the monitoring data;
   - simulating, with the trained machine learning model, a rate of users leaving the web application based on the virtual performance metrics;
   - identifying at least one modified performance metric from the virtual performance metrics causing a change in the rate of users leaving the web application; and
   - outputting a recommendation specific to the web application based on the at least one modified performance metric causing the change in the rate of users leaving the web application.

2. The computer-implemented method according to claim 1, further comprising preprocessing the monitoring data prior to training the machine learning model.

3. The computer-implemented method according to claim 2, wherein:

the performance metrics in the monitoring data are at least partially represented by categorical variables; and preprocessing the monitoring data includes generating a matrix with the categorical variables split into distinct columns each specific to a performance metric of the performance metrics.

4. The computer-implemented method according to claim 3, wherein preprocessing the monitoring data includes at least one of:

- identifying missing values for the categorical variables in the matrix; and filling the missing values in the matrix;
- splitting the monitoring data includes a plurality of data sets including a first data set with data having influence on users leaving the web application, a second data set with data having no influence on users leaving the web application, and a third data set with data registering users leaving the web application; and
- generating the training data for the machine learning model with only the first data set with data having influence on users leaving the web application.

5. The computer-implemented method according to any one of the preceding claims, further comprising identifying the recommendation specific to the web application based on an inflection point of a simulation curve for user retention results from the simulation.

6. The computer-implemented method according to any one of the preceding claims, wherein:

- simulating a rate of users leaving the web application includes simulating, multiple times with the trained machine learning model, a rate of users leaving the web application based on the virtual performance metrics having different modifications to the performance metrics in the monitoring data, each simulation with the trained machine learning model is based on a different modification to the performance metrics in the monitoring data; and
- the computer-implemented method further comprises comparing user retention results from the multiple simulations based on the different modifications to the performance metrics in the monitoring data, and ranking the virtual performance metrics based on the user retention results.

7. The computer-implemented method according to claim 6, further comprising identifying the recommendation based on the ranking of the virtual performance metrics.

8. The computer-implemented method according to any one of the preceding claims, wherein the machine learning model is a Gradient Boosting Machine model and/or utilizes monotonic constraints.

9. A computer-implemented method for optimizing performance of a web application, the computer-implemented method comprising:

- collecting monitoring data associated with interactions between users and the web application, the monitoring data comprising performance metrics related to the performance of the web application and events for users leaving the web application;
- training a machine learning model with training data, wherein the training data is a subset of the monitoring data;
- generating virtual performance metrics for the web application by modifying one or more of the performance metrics in the monitoring data;
- simulating, with the trained machine learning model, a rate of users leaving the web application based on the virtual performance metrics;
- identifying one modified performance metric from the virtual performance metrics causing a change in the rate of users leaving the web application; and
- modifying the web application such that the performance metrics of the web application corresponds to or resembles the identified modified performance metric to optimize the performance of the web application.

10. The computer-implemented method according to claim 9, further comprises preprocessing the monitoring data prior to training the machine learning model.

11. The computer-implemented method according to claim 10, wherein:

- the performance metrics in the monitoring data are at least partially represented by categorical variables; and
- preprocessing the monitoring data includes generating a matrix with the categorical variables split into distinct columns each specific to a performance metric of the performance metrics,

wherein preferably preprocessing the monitoring data includes identifying missing values for the categorical variables in the matrix; and filling the missing values in the matrix.

12. The computer-implemented method according to claim 11, wherein preprocessing the monitoring data includes:

- splitting the monitoring data includes a plurality of data sets including a first data set with data having influence on users leaving the web application, a second data set with data having no influence on users leaving the web application, and a third data set with data registering users leaving the web application; and
- generating the training data for the machine learning model with only the first data set with data having influence on users leaving the web application.

13. The computer-implemented method according to any one of claims 9 to 12, wherein:

- simulating a rate of users leaving the web application includes simulating, multiple times with the trained machine learning model, a rate of users leaving the web application based on the virtual performance metrics having different modifications to the performance metrics in the monitoring data, each simulation with the trained machine learning model is based on a different modification to the performance metrics in the monitoring data; and
- the computer-implemented method further comprises comparing user retention results from the multiple simulations based on the different modifications to the performance metrics in the monitoring data, and ranking the virtual performance metrics based on the user retention results,

wherein the method preferably comprises modifying the web application including modifying the web application based on the ranking of the virtual performance metrics.

14. The computer-implemented method according to any one of claims 9 to 13, wherein the machine learning model is a Gradient Boosting Machine model and/or utilizes monotonic constraints.

15. A non-transitory computer-readable medium having computer-executable instructions that, upon execution of the instructions by a processor of a computer, cause the computer to:

- collect monitoring data associated with interactions between users and a web application, the monitoring data comprising performance metrics related to performance of the web application and events for users leaving the web application;
- train a machine learning model with training data, wherein the training data is a subset of the monitoring data;
- generate virtual performance metrics for the web application by modifying one or more of the performance metrics in the monitoring data;
- simulate, with the trained machine learning model, a rate of users leaving the web application based on the virtual performance metrics;
- identify one modified performance metric from the virtual performance metrics causing a change in the rate of users leaving the web application; and
- modify the web application such that the performance metrics of the web application corresponds to or resembles the identified modified performance metric to optimize the performance of the web application.

Fig. 1

# Fig. 2

EP 4 654 022 A2

# Fig. 3

SPEED_INDEX

LOAD_EVENT_END

VISUALLY_COMPLETE_TIME

LARGEST_CONTENTFUL_PAINT

DOM_COMPLETE_TIME

FIRST_INPUT_DELAY

REQUEST_START

RESPONSE_END

CUMULATIVE_LAYOUT_SHIFT

REQUEST_ERRORS

Failed image

HTTP 500

HTTP 401

...

JAVASCRIPT_ERRORS

TypeError

InvalidState

AxiosError

...

P(IS_EXIT)

p

BROWSER_TYPE

ACTION_NAME

ACTION_INDEX

IS_NEW_USER

SCREEN_ORIENTA TION

DISPLAY_RESOLUT ION

COUNTRY

REGION

BROWSER_FAMILY

ISP

p - Covariate matrix
R - bot removal
↪ M - model controller
Monotone relation

**Fig. 4**

p - Covariate matrix
R - bot removal
M - model controller
Monotone relation

**Fig. 5**

**Fig. 6**

**Fig. 7**

Fig. 8

Fig. 9

## Fig. 10/Tab. 1

| SESSION_ID | ACTION_NAME | ISP | SPEED_INDEX | VISUALLY_COMPLETE_TIME | ERROR_NAMES | IS_EXIT |
|---|---|---|---|---|---|---|
| 1 | Page 1 | ISP 1 | 1.5 | 2 | | 0 |
| 1 | Page 2 | ISP 1 | 1 | 3 | CSP rule violation | 0 |
| 1 | Page 3 | ISP 1 | 2 | 2.5 | Failed Image,CSP rule violation | 1 |
| 2 | Page 2 | ISP 2 | 1.5 | 2 | | 0 |
| 2 | Page 1 | ISP 2 | 6 | 3 | | 1 |
| 3 | Page 3 | | 3 | 2.5 | | 0 |
| 3 | Page 1 | | 1.5 | 2 | Failed Image | 1 |
| 4 | Page 2 | ISP 1 | 1 | 2.5 | | 0 |
| 4 | Page 1 | ISP 1 | 2 | 3 | | 0 |
| 4 | Page 3 | ISP 1 | 6 | 1.5 | Failed Image | 1 |

## Fig. 11/Tab. 2

| SESSION_ID | ACTION_NAME | ISP | SPEED_INDEX | VISUALLY_COMPLETE_TIME | ERROR_NAMES | IS_EXIT |
|---|---|---|---|---|---|---|
| 1 | Page 1 | ISP 1 | 1.5 | 2 | | 0 |
| 1 | Page 2 | ISP 1 | 1 | 3 | CSP rule violation | 0 |
| 1 | Page 3 | ISP 1 | 2 | 2.5 | Failed Image,CSP rule violation | 1 |
| 2 | Page 2 | ISP 2 | 1.5 | 2 | | 0 |
| 2 | Page 1 | ISP 2 | 6 | 3 | | 1 |
| 3 | Page 3 | **UNKNOWN** | 3 | 2.5 | | 0 |
| 3 | Page 1 | **UNKNOWN** | 1.5 | 2 | Failed Image | 1 |
| 4 | Page 2 | ISP 1 | 1 | 2.5 | | 0 |
| 4 | Page 1 | ISP 1 | 2 | 3 | | 0 |
| 4 | Page 3 | ISP 1 | 6 | 1.5 | Failed Image | 1 |

## Fig. 12/Tab. 3

| SESSION_ID | ACTION_NAME | ISP | SPEED_INDEX | VISUALLY_COMPLETE_TIME | ERROR_NAMES | IS_EXIT |
|---|---|---|---|---|---|---|
| 1 | Page 1 | ISP 1 | 1.5 | 2 | | 0 |
| 1 | Page 2 | ISP 1 | 1 | 3 | CSP rule violation | 0 |
| 1 | Page 3 | ISP 1 | 2 | 2.5 | Failed Image, CSP rule violation | 1 |
| 2 | Page 2 | ISP 2 | 1.5 | 2 | | 0 |
| 2 | Page 1 | ISP 2 | 6 | 3 | | 1 |
| 3 | Page 3 | UNKNOWN | 3 | 2.5 | | 0 |
| 3 | Page 1 | UNKNOWN | 1.5 | 2 | Failed Image | 1 |
| 4 | Page 2 | ISP 1 | 1 | 2.5 | | 0 |
| 4 | Page 1 | ISP 1 | 2 | 3 | | 0 |
| 4 | Page 3 | ISP 1 | 6 | 1.5 | Failed Image | 1 |

p — x — y

## Fig. 13/Tab. 4

| AN_P1 | AN_P2 | AN_P3 | ISP_1 | ISP_2 | ISP_U | SI | VCT | EN_CSP | EN_FI | IS_EXIT |
|---|---|---|---|---|---|---|---|---|---|---|
| 1 | 0 | 0 | 1 | 0 | 0 | 1.5 | 2 | 0 | 0 | 0 |
| 0 | 1 | 0 | 1 | 0 | 0 | 1 | 3 | 1 | 0 | 0 |
| 0 | 0 | 1 | 1 | 0 | 0 | 2 | 2.5 | 1 | 1 | 1 |
| 0 | 1 | 0 | 0 | 1 | 0 | 1.5 | 2 | 0 | 0 | 0 |
| 1 | 0 | 0 | 0 | 1 | 0 | 6 | 3 | 0 | 0 | 1 |
| 0 | 0 | 1 | 0 | 0 | 1 | 3 | 2.5 | 0 | 0 | 0 |
| 1 | 0 | 0 | 0 | 0 | 1 | 1.5 | 2 | 0 | 1 | 1 |
| 0 | 1 | 0 | 1 | 0 | 0 | 1 | 2.5 | 0 | 0 | 0 |
| 1 | 0 | 0 | 1 | 0 | 0 | 2 | 3 | 0 | 0 | 0 |
| 0 | 0 | 1 | 1 | 0 | 0 | 6 | 1.5 | 0 | 1 | 1 |

A

## Fig. 14/Tab. 5

| | AN_P1 | AN_P2 | AN_P3 | ISP_1 | ISP_2 | ISP_U | SI | VCT | EN_CSP | EN_FI | | IS_EXIT* |
|---|---|---|---|---|---|---|---|---|---|---|---|---|
| 1 | 1 | 0 | 0 | 1 | 0 | 0 | 1.5 | 2 | 0 | 0 | | 0 |
| 2 | 0 | 1 | 0 | 1 | 0 | 0 | 1 | 3 | 1 | 0 | | 0 |
| 3 | 0 | 0 | 1 | 1 | 0 | 0 | 2 | 2.5 | 1 | **1** | | **1** |
| 4 | 0 | 1 | 0 | 0 | 1 | 0 | 1.5 | 2 | 0 | 0 | | 0 |
| 5 | 1 | 0 | 0 | 0 | 1 | 0 | **6** | 3 | 0 | 0 | | **1** |
| 6 | 0 | 0 | 1 | 0 | 0 | 1 | 3 | 2.5 | 0 | 0 | | 0 |
| 7 | 1 | 0 | 0 | 0 | 0 | 1 | 1.5 | 2 | 0 | **1** | | **1** |
| 8 | 0 | 1 | 0 | 1 | 0 | 0 | 1 | 2.5 | 0 | 0 | | 0 |
| 9 | 1 | 0 | 0 | 1 | 0 | 0 | 2 | 3 | 0 | 0 | | 0 |
| 10 | 0 | 0 | 1 | 1 | 0 | 0 | **6** | 1.5 | 0 | **1** | | **1** |

## Fig. 15/Tab. 6: Fix CSP errors

| | AN_P1 | AN_P2 | AN_P3 | ISP_1 | ISP_2 | ISP_U | SI | VCT | EN_CSP | EN_FI | | IS_EXIT* |
|---|---|---|---|---|---|---|---|---|---|---|---|---|
| 1 | 1 | 0 | 0 | 1 | 0 | 0 | 1.5 | 2 | 0 | 0 | | 0 |
| 2 | 0 | 1 | 0 | 1 | 0 | 0 | 1 | 3 | **0** | 0 | | 0 |
| 3 | 0 | 0 | 1 | 1 | 0 | 0 | 2 | 2.5 | **0** | 1 | | 1 |
| 4 | 0 | 1 | 0 | 0 | 1 | 0 | 1.5 | 2 | 0 | 0 | | 0 |
| 5 | 1 | 0 | 0 | 0 | 1 | 0 | 6 | 3 | 0 | 0 | | 1 |
| 6 | 0 | 0 | 1 | 0 | 0 | 1 | 3 | 2.5 | 0 | 0 | | 0 |
| 7 | 1 | 0 | 0 | 0 | 0 | 1 | 1.5 | 2 | 0 | 1 | | 1 |
| 8 | 0 | 1 | 0 | 1 | 0 | 0 | 1 | 2.5 | 0 | 0 | | 0 |
| 9 | 1 | 0 | 0 | 1 | 0 | 0 | 2 | 3 | 0 | 0 | | 0 |
| 10 | 0 | 0 | 1 | 1 | 0 | 0 | 6 | 1.5 | 0 | 1 | | 1 |

## Fig. 16/Tab. 7: Fix failed image errors

| | AN_P1 | AN_P2 | AN_P3 | ISP_1 | ISP_2 | ISP_U | SI | VCT | EN_CSP | EN_FI | | IS_EXIT* |
|---|---|---|---|---|---|---|---|---|---|---|---|---|
| 1 | 1 | 0 | 0 | 1 | 0 | 0 | 1.5 | 2 | 0 | 0 | | 0 |
| 2 | 0 | 1 | 0 | 1 | 0 | 0 | 1 | 3 | 1 | 0 | | 0 |
| 3 | 0 | 0 | 1 | 1 | 0 | 0 | 2 | 2.5 | 1 | 0 | | 0 |
| 4 | 0 | 1 | 0 | 0 | 1 | 0 | 1.5 | 2 | 0 | 0 | | 0 |
| 5 | 1 | 0 | 0 | 0 | 1 | 0 | 6 | 3 | 0 | 0 | | 1 |
| 6 | 0 | 0 | 1 | 0 | 0 | 1 | 3 | 2.5 | 0 | 0 | | 0 |
| 7 | 1 | 0 | 0 | 0 | 0 | 1 | 1.5 | 2 | 0 | 0 | | 0 |
| 8 | 0 | 1 | 0 | 1 | 0 | 0 | 1 | 2.5 | 0 | 0 | | 0 |
| 9 | 1 | 0 | 0 | 1 | 0 | 0 | 2 | 3 | 0 | 0 | | 0 |
| 10 | 0 | 0 | 1 | 1 | 0 | 0 | 6 | 1.5 | 0 | 0 | | 1 |

## Fig. 17/Tab. 8: Improve visually complete by 20%

| | AN_P1 | AN_P2 | AN_P3 | ISP_1 | ISP_2 | ISP_U | SI | VCT | EN_CSP | EN_FI | | IS_EXIT* |
|---|---|---|---|---|---|---|---|---|---|---|---|---|
| 1 | 1 | 0 | 0 | 1 | 0 | 0 | 1.5 | 1.6 | 0 | 0 | | 0 |
| 2 | 0 | 1 | 0 | 1 | 0 | 0 | 1 | 2.4 | 1 | 0 | | 0 |
| 3 | 0 | 0 | 1 | 1 | 0 | 0 | 2 | 2 | 1 | 1 | | 1 |
| 4 | 0 | 1 | 0 | 0 | 1 | 0 | 1.5 | 1.6 | 0 | 0 | | 0 |
| 5 | 1 | 0 | 0 | 0 | 1 | 0 | 6 | 2.4 | 0 | 0 | | 1 |
| 6 | 0 | 0 | 1 | 0 | 0 | 1 | 3 | 2 | 0 | 0 | | 0 |
| 7 | 1 | 0 | 0 | 0 | 0 | 1 | 1.5 | 1.6 | 0 | 1 | | 1 |
| 8 | 0 | 1 | 0 | 1 | 0 | 0 | 1 | 2 | 0 | 0 | | 0 |
| 9 | 1 | 0 | 0 | 1 | 0 | 0 | 2 | 2.4 | 0 | 0 | | 0 |
| 10 | 0 | 0 | 1 | 1 | 0 | 0 | 6 | 1.2 | 0 | 1 | | 1 |

## Fig. 18/Tab. 9: Improve speed index by 15%

|    | AN_P1 | AN_P2 | AN_P3 | ISP_1 | ISP_2 | ISP_U | SI   | VCT | EN_CSP | EN_FI | IS_EXIT* |
|----|-------|-------|-------|-------|-------|-------|------|-----|--------|-------|----------|
| 1  | 1     | 0     | 0     | 1     | 0     | 0     | 1.29 | 2   | 0      | 0     | 0        |
| 2  | 0     | 1     | 0     | 1     | 0     | 0     | 0.86 | 3   | 1      | 0     | 0        |
| 3  | 0     | 0     | 1     | 1     | 0     | 0     | 1.71 | 2.5 | 1      | 1     | 1        |
| 4  | 0     | 1     | 0     | 0     | 1     | 0     | 1.29 | 2   | 0      | 0     | 0        |
| 5  | 1     | 0     | 0     | 0     | 1     | 0     | 5.14 | 3   | 0      | 0     | 0        |
| 6  | 0     | 0     | 1     | 0     | 0     | 1     | 2.57 | 2.5 | 0      | 0     | 0        |
| 7  | 1     | 0     | 0     | 0     | 0     | 1     | 1.29 | 2   | 0      | 1     | 1        |
| 8  | 0     | 1     | 0     | 1     | 0     | 0     | 0.86 | 2.5 | 0      | 0     | 0        |
| 9  | 1     | 0     | 0     | 1     | 0     | 0     | 1.71 | 3   | 0      | 0     | 0        |
| 10 | 0     | 0     | 1     | 1     | 0     | 0     | 5.14 | 1.5 | 0      | 1     | 1        |

# Fig. 19

ERROR_NAMES_RE_Failed_image Page 1

ERROR_NAMES_RE_CSP_rule_violation Page 1

SPEED_INDEX Page 1

VISUALLY_COMPLETE_TIME Page 1

## Fig. 20/Tab. 10

| | SESSION_ID | ACTION_NAME | ISP | SPEED_INDEX | VISUALLY_COMPLETE_TIME | ERROR_NAMES | IS_EXIT |
|---|---|---|---|---|---|---|---|
| 0 | 1 | Page 3 | ISP 1 | 0.444060 | 1.012396 | None | 0 |
| 1 | 1 | Page 3 | ISP 1 | 1.159451 | 0.821474 | None | 0 |
| 2 | 1 | Page 3 | ISP 1 | 0.765263 | 0.514409 | Failed Image | 1 |
| 3 | 2 | Page 1 | ISP 2 | 1.271280 | 0.802362 | None | 0 |
| 4 | 2 | Page 3 | ISP 2 | 10.111039 | 0.779903 | Failed Image | 1 |
| 5 | 3 | Page 1 | None | 9.616012 | 0.925281 | Failed Image | 1 |
| 6 | 4 | Page 2 | ISP 2 | 1.145517 | 0.713230 | None | 0 |
| 7 | 4 | Page 3 | ISP 2 | 9.682220 | 0.926998 | Failed Image | 1 |
| 8 | 5 | Page 2 | ISP 2 | 0.335907 | 0.864048 | None | 0 |
| 9 | 5 | Page 2 | ISP 2 | 10.098431 | 0.814828 | Failed Image | 1 |

## Fig. 21/Tab. 11

| | SESSION_ID | AN_P1 | AN_P2 | AN_P3 | ISP_1 | ISP_2 | ISP_U | SI | VCT | EN_CSP | EN_FI | IS_EXIT |
|---|---|---|---|---|---|---|---|---|---|---|---|---|
| 0 | 1 | 0.0 | 0.0 | 1.0 | 1.0 | 0.0 | 0.0 | 0.444060 | 1.012396 | 0 | 0 | 0 |
| 1 | 1 | 0.0 | 0.0 | 1.0 | 1.0 | 0.0 | 0.0 | 1.159451 | 0.821474 | 0 | 0 | 0 |
| 2 | 1 | 0.0 | 0.0 | 1.0 | 1.0 | 0.0 | 0.0 | 0.765263 | 0.514409 | 0 | 1 | 1 |
| 3 | 2 | 1.0 | 0.0 | 0.0 | 0.0 | 1.0 | 0.0 | 1.271280 | 0.802362 | 0 | 0 | 0 |
| 4 | 2 | 0.0 | 0.0 | 1.0 | 0.0 | 1.0 | 0.0 | 10.111039 | 0.779903 | 0 | 1 | 1 |
| 5 | 3 | 1.0 | 0.0 | 0.0 | 0.0 | 0.0 | 1.0 | 9.616012 | 0.925281 | 0 | 1 | 1 |
| 6 | 4 | 0.0 | 1.0 | 0.0 | 0.0 | 1.0 | 0.0 | 1.145517 | 0.713230 | 0 | 0 | 0 |
| 7 | 4 | 0.0 | 0.0 | 1.0 | 0.0 | 1.0 | 0.0 | 9.682220 | 0.926998 | 0 | 1 | 1 |
| 8 | 5 | 0.0 | 1.0 | 0.0 | 0.0 | 1.0 | 0.0 | 0.335907 | 0.864048 | 0 | 0 | 0 |
| 9 | 5 | 0.0 | 1.0 | 0.0 | 0.0 | 1.0 | 0.0 | 10.098431 | 0.814828 | 0 | 1 | 1 |

X      y

## Fig. 22/Tab. 12

| | Page | Metric | Value | Exit_rate | Type |
|---|---|---|---|---|---|
| 0 | ACTION_NAME_Page 3 | CSP rule violation | 0.010640 | 0.500656 | current |
| 1 | ACTION_NAME_Page 3 | CSP rule violation | 0.000000 | 0.500656 | target |
| 2 | ACTION_NAME_Page 3 | Failed Image | 0.495321 | 0.500656 | current |
| 3 | ACTION_NAME_Page 3 | Failed Image | 0.000000 | 0.447675 | target |
| 4 | ACTION_NAME_Page 3 | SPEED_INDEX | 1.662043 | 0.500656 | current |
| 5 | ACTION_NAME_Page 3 | SPEED_INDEX | 1.500000 | 0.450947 | target |
| 6 | ACTION_NAME_Page 3 | SPEED_INDEX | 1.000000 | 0.298331 | simulation |
| 7 | ACTION_NAME_Page 3 | VISUALLY_COMPLETE_TIME | 0.851442 | 0.500656 | current |
| 8 | ACTION_NAME_Page 1 | CSP rule violation | 0.010136 | 0.501881 | current |
| 9 | ACTION_NAME_Page 1 | CSP rule violation | 0.000000 | 0.501881 | target |
| 10 | ACTION_NAME_Page 1 | Failed Image | 0.496984 | 0.501881 | current |
| 11 | ACTION_NAME_Page 1 | Failed Image | 0.000000 | 0.449122 | target |
| 12 | ACTION_NAME_Page 1 | SPEED_INDEX | 1.683770 | 0.501881 | current |
| 13 | ACTION_NAME_Page 1 | SPEED_INDEX | 1.500000 | 0.445861 | target |
| 14 | ACTION_NAME_Page 1 | SPEED_INDEX | 1.000000 | 0.295465 | simulation |
| 15 | ACTION_NAME_Page 1 | VISUALLY_COMPLETE_TIME | 0.851302 | 0.501881 | current |
| 16 | ACTION_NAME_Page 2 | CSP rule violation | 0.009941 | 0.496459 | current |
| 17 | ACTION_NAME_Page 2 | CSP rule violation | 0.000000 | 0.496459 | target |
| 18 | ACTION_NAME_Page 2 | Failed Image | 0.491414 | 0.496459 | current |
| 19 | ACTION_NAME_Page 2 | Failed Image | 0.000000 | 0.444284 | target |
| 20 | ACTION_NAME_Page 2 | SPEED_INDEX | 1.655763 | 0.496459 | current |
| 21 | ACTION_NAME_Page 2 | SPEED_INDEX | 1.500000 | 0.449049 | target |
| 22 | ACTION_NAME_Page 2 | SPEED_INDEX | 1.000000 | 0.297105 | simulation |

## Fig. 23

Start

110 → Collect Monitoring Data

120 → Preprocess Monitoring Data

130 → Train ML Model

140 → Generate Virtual Performance Metrics

150 → Simulate Exit rates

END

## Fig. 24

Start

210 → Collect Monitoring Data

220 → Preprocess Monitoring Data

230 → Train ML Model

240 → Generate Virtual Performance Metrics

250 → Simulate Exit rates

260 → Optimize Web App

END